# EUROPÄISCHE PATENTANMELDUNG

(11) **EP 2 782 132 A2**
(43) Veröffentlichungstag der Anmeldung: **24.09.2014**
(21) Anmeldenummer: 14154233.2
(22) Anmeldetag: 07.02.2014
(51) Int. Cl.: H01L 23/24, H01L 23/29, H01L 23/538

(54) **Leistungsbaugruppe mit einer als Folienverbund ausgebildeten Verbindungseinrichtung**

(30) Priorität: 20.03.2013 DE 102013102828
(71) Anmelder: SEMIKRON Elektronik GmbH & Co. KG, 90431 Nürnberg (DE)
(72) Erfinder: Sagebaum, Ulrich, 90537 Feucht (DE); Klem, Gregor, 90449 Nürnberg (DE); Schmitt, Stefan, 90766 Fürth (DE)

(57) **Zusammenfassung**

Es wird eine Leistungsbaugruppe mit einem aufweisendem Substrat mit Leistungshalbleiterbauelementen und mit einer Verbindungeinrichtung, ausgebildet als Folienverbund mit einer isolierenden Folie und einer elektrisch leitenden Folie, die in mit einer Kontaktfläche eines Leistungshalbleiterbauelements oder einer Leiterbahn des Substrats verbunden ist, wobei der Folienverbund aufweist: eine Mehrzahl in gleichem Abstand zueinander verlaufender einfacher Schlitze, wobei zwei benachbarte einfache Schlitze keinen durchgängig geraden Verlauf aufweisen und / oder einen ersten breiten Schlitz, der von einer Kontaktfläche ausgehend über den Rand dieser Kontaktfläche hinausragt, und / oder einen zweiten breiten Schlitz, der den mit einer Kontaktfläche in Kontakt stehenden Abschnitt der elektrisch leitenden Folie in zwei nicht direkt miteinander elektrisch leitend verbundene Folienleiterbahnen unterbricht.

## Beschreibung

Die Erfindung beschreibt eine Leistungsbaugruppe, wie sie beispielhaft in Leistungshalbleitermodulen oder als Teilkomponenten in leistungselektronischen Systemen eingesetzt wird. Eine derartige Leistungsbaugruppe weist ein Substrat mit Leiterbahnen und hierauf angeordneten Leistungshalbleiterbauelementen auf. Diese Leistungshalbleiterbauelemente sind miteinander oder mit den Leiterbahnen mittels interner Verbindungseinrichtungen schaltungsgerecht elektrisch leitend verbunden.

Fachüblich sind verschiede Ausgestaltungen der Substrate beispielhaft als Substrate mit keramischen Isolierstoffkörpern und hierauf angeordneten Leiterbahnen. Ebenso fachüblich sind verschiedenen Ausgestaltungen und Kombinationen von Leistungshalbleiterbauelementen insbesondere ausgestaltet als Leistungstransistoren häufig geeignet verschaltet mit Leistungsdioden oder als Leistungsthyristoren. Weiterhin sind die Verbindungseinrichtungen fachüblich als Drahtbondverbindungen oder als Folienverbund mit einer abwechselnden Anordnung von leitenden und isolierenden Folienlage, wobei in der Regel mindestens eine dieser Folienlagen in sich strukturiert ist und im Falle leitender Folienlagen Folienleiterbahnen der Folie ausbilden.

Den grundlegenden Stand der Technik hierzu bildet beispielhaft die DE 103 55 925 A1, wobei insbesondere die hier vorgesehene stoffschlüssige Verbindung, eine Schweißverbindung nur exemplarisch zu verstehen ist. Gleichwirkend im Rahmen dieser Erfindung sind hierzu auch andere stoffschlüssige Verbindungen, wie Lot-, insbesondere Diffusionslotverbindungen oder Sinter-, insbesondere Drucksinterverbindungen.

Häufig wird bei derartigen Leistungsbaugruppen ein Bauteil, meist ein Leistungshalbleiterbauelement, von einem Isolierstoff zumindest teilweise umschlossen, wie dies in der DE 10 2007 006 706 A1 offenbart ist. Nachteilig an derartigen Isolierstoffen ist allerdings, dass deren Wärmeausdehnungskoeffizient wesentlich, beispielhaft um eine oder zwei Größenordnungen über demjenigen Wärmeausdehnungskoeffizient des Substrat oder der Leistungshalbleiterbauelemente liegt. Bei Temperaturerhöhung im Betrieb der Leistungsbaugruppe dehnt sich daher der Isolierstoff wesentlich stärker und durch die gegebene Bedingungen von der Substratoberfläche weggerichtet in Richtung der Verbindungseinrichtung aus. Hierdurch wird diese Verbindungseinrichtung insbesondere im Randbereich von Leistungshalbleiterbauelementen stark beansprucht. Diese Beanspruchung kann benachbarte stoffschlüssige Verbindungen zwischen Leistungshalbleiterbauelement und Verbindungseinrichtung stark belasten und deren Dauerhaltbarkeit reduzieren.

In Kenntnis des oben genannten Standes der Technik liegt der Erfindung die Aufgabe zugrunde, eine Leistungsbaugruppe mit einer als Folienverbund ausgebildeten internen Verbindungseinrichtung vorzustellen bei der die Belastung auf stoffschlüssige Verbindungen des Folienverbundes mit einer Kontaktfläche des Substrats oder eines Leistungshalbleiterbauelements reduziert ist.

Diese Aufgabe wird erfindungsgemäß gelöst durch eine Leistungsbaugruppe mit den Merkmalen des Anspruchs 1. Bevorzugte Ausführungsformen sind in den abhängigen Ansprüchen beschrieben.

Die Erfindung beschreibt eine Leistungsbaugruppe mit einem Leiterbahnen aufweisendem Substrat, hierauf angeordneten Leistungshalbleiterbauelementen und mit einer Verbindungeinrichtung. Diese Verbindungseinrichtung ist ausgebildet als ein Folienverbund mit einer elektrisch isolierenden und einer elektrisch leitenden Folie, die in Abschnitten jeweils mit einer Kontaktfläche eines Leistungshalbleiterbauelements oder mit einer Kontaktfläche einer Leiterbahn des Substrats stoffschlüssig verbunden ist. Selbstverständlich kann der Folienverbund jeweils auch eine Mehrzahl derartiger Folien aufweisen, wobei sich isolierende und elektrisch leitende Folien abwechseln. Der Folienverbund weist eine Mehrzahl in gleichem Abstand zueinander verlaufender einfacher Schlitze auf, wobei zwei benachbarte einfache Schlitze keinen durchgängig geraden Verlauf aufweisen, sondern jeder einfache Schlitz mindestens einen Abstandspunkt in seinem Verlauf aufweist, der von der die Eckpunkte des einfachen Schlitzes verbindenden Geraden einen minimalen Abstand aufweist, der größer ist als der maximale Abstand zum in diese Richtung benachbarten einfachen Schlitz. Die Eckpunkte sind definiert als die Anfangs- und Endpunkte eines Schlitzes. Der Abstandspunkt ist festgelegt als derjenige Punkt mit dem größten Abstand von dieser Geraden.

Alternativ oder gleichzeitig weist der Folienverbund einen ersten breiten Schlitz, der von einer Kontaktfläche eines Leistungshalbleiterbauelements oder einer Leiterbahn eines Substrats ausgehend über den Rand dieser Kontaktfläche hinausragt, auf.

Alternativ oder gleichzeitig weist der Folienverbund einen zweiten breiten Schlitz auf, der den mit einer Kontaktfläche eines Leistungshalbleiterbauelements oder einer Leiterbahn eines Substrats in Kontakt stehenden Abschnitt der elektrisch leitenden Folie in zwei nicht direkt miteinander elektrisch leitend verbundenen Teilabschnitte, Folienleiterbahnen, unterbricht auf.

Unter "einfacher Schlitz" soll hier und im Folgenden eine schlitzartige, in ihrer Länge begrenzte Unterbrechung mindestens einer Folienlage verstanden werden, wobei bei Ausbildung eines einfachen Schlitzes keine Beabstandung der Ränder erzeugt wird. Derartige einfache Schlitze sind beispielhaft als Schnitte, auch mittels Laserschneidverfahren erzeugt, ausgebildet. Unter "breiter Schlitz" soll hier und im Folgenden eine schlitzartige in ihrer Länge begrenzte Unterbrechung mindestens einer Folienlage verstanden werden, wobei die Ausbildung als breiter Schlitz einem Abstand der Ränder längs des Verlaufes des Schlitzes selbst bedingt. Derartige breite Schlitze sind beispielhaft durch Materialabtrag ausgebildet und können bespielhaft mittels eines Ätzverfahrens oder durch Laserabtrag ausgebildet sein.

Unter "durchgehender Schlitz" soll hier und im Folgenden ein einfacher oder breiter Schlitz verstanden werden der durch alle Folienlagen der Verbindungseinrichtung hindurch reicht. Unter "Schlitz einer Folienlage" soll hier und im Folgenden ein einfacher oder breiter Schlitz verstanden werden, der durch ausschließlich eine Folienlage hindurch reicht.

Diese verschiedenen Arten von Schlitzen werden gemeinsam als Ausprägungen von Schlitzen bezeichnet.

Unter "Vergussmasse" soll hier und im Folgenden ein, beispielhaft gelartiger, Isolierstoff verstanden werden, der an mindestens einen Seite eines Leistungshalbleiterbauelements angeordnet ist. Eine Vergussmasse wird vorzugsweise mittels eines Gies- oder Schablonendruckverfahrens angeordnet.

Grundsätzlich ist es vorteilhaft, wenn bei einem einfachen Schlitz der Abstand des Abstandspunktes von der die Eckpunkte verbindenden Geraden mindestens dem 1,5-fachen, insbesondere mindestens dem 2-fachen, des Abstandes korrespondierender benachbarter Schlitze entspricht.

Ebenfalls kann es häufig vorteilhaft sein, wenn ein einfacher, ein erster breiter oder ein zweiter breiter Schlitz, als ein Schlitz einer Ausprägung in einen Schlitz einer anderen Ausprägung übergeht.

Zudem kann es hierbei von Vorteil sein, wenn bei einem Übergang von einem Schlitz einer Ausprägung in einen Schlitz anderer Ausprägung, die beiden Schlitze am Übergangspunkt einen Winkel zueinander einschließen. Hierbei kann der Übergangspunkt am Ende eines Schlitzes und im Verlauf, also nicht an einem Ende, des Schlitzes anderer Ausprägung liegen.

Alternativ hierzu können bei einem Übergang von einem Schlitz einer Ausprägung in einen Schlitz anderer Ausprägung, die beiden Schlitze am Übergangspunkt zueinander fluchten.

Eine bevorzugte Ausbildung der Erfindung besteht darin, dass eine Mehrzahl einfacher Schlitze mit gleichem Abstand zueinander ausgebildet sind mit jeweils drei Parallelabschnitten, wobei der erste und dritte Parallelabschnitt auf einer gedachten Geraden angeordnet sind während der zweite Parallelabschnitt, auf dem der Abstandspunkt angeordnet ist, zu den anderen Parallelabschnitten parallel beabstandet verläuft.

Bei einfachen Schlitzen ist es zudem bevorzugt, wenn sie jeweils als durchgehender Schlitz ausgebildet sind. Bei ersten und / oder ein zweiten breiten Schlitzen kann es dagegen bevorzugt sein, wenn sie jeweils als Schlitz nur einer Folienlage einer leitenden Folie ausgebildet sind.

Es versteht sich, dass die verschiedenen Ausgestaltungen der Erfindung einzeln oder in beliebigen sich nicht ausschließenden Kombinationen realisiert sein können, um Verbesserungen zu erreichen. Insbesondere sind die vorstehend genannten und erläuterten Merkmale nicht nur in den angegebenen Kombinationen, sondern auch in anderen Kombinationen oder in Alleinstellung einsetzbar, ohne den Rahmen der vorliegenden Erfindung zu verlassen.

Weitere Erläuterung der Erfindung, vorteilhafte Einzelheiten und Merkmale ergeben sich aus der nachfolgenden Beschreibung der in den Fig. 1 bis 7 dargestellten Ausführungsbeispiele der erfindungsgemäßen Verbindungseinrichtung einer Anordnung hiermit oder von Teilen hiervon. Dabei zeigen:
Figur 1 und 2 einen schematischen Teilschnitt durch eine erfindungsgemäße Leistungsbaugruppe in seitlicher Schnittdarstellung bei verschiedenen thermischen Bedingungen;
Figur 3 eine schematische Draufsicht auf eine erfindungsgemäße Leistungsbaugruppe;
Figur 4 eine schematische Teilansicht einer erfindungsgemäßen Leistungsbaugruppe in Draufsicht;
Figur 5 eine schematische Schnittansicht einer erfindungsgemäßen Leistungsbaugruppe;
Figur 6 eine weitere schematische Draufsicht auf eine erfindungsgemäße Leistungsbaugruppe;
Figur 7 eine erfindungsgemäße Leistungsbaugruppe in schematisierter Teilansicht.

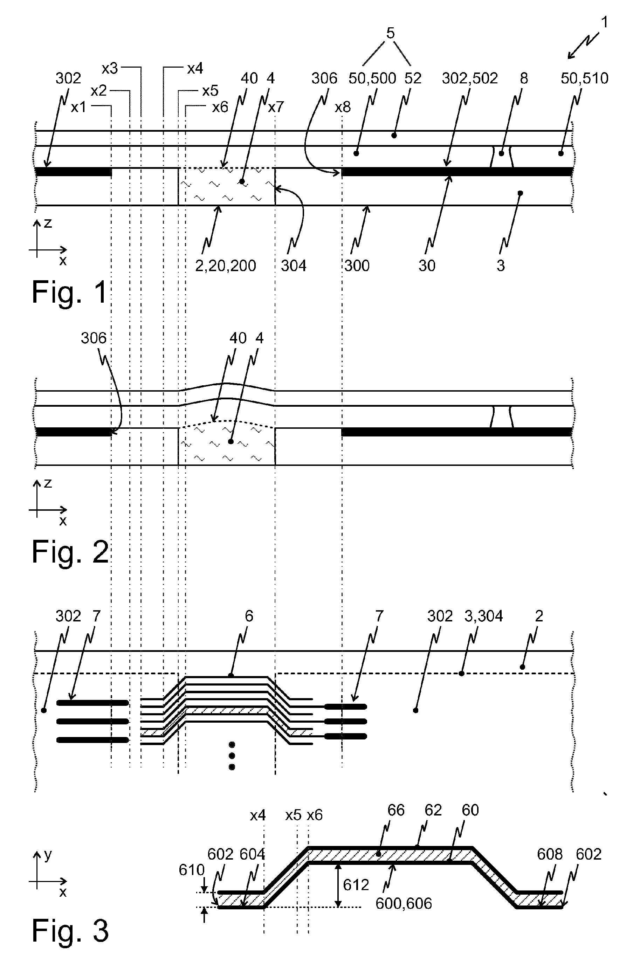

Figur 1 und 2 zeigen einen schematischen Teilschnitt durch eine erfindungsgemäße Leistungsbaugruppe 1 in seitlicher Schnittdarstellung bei verschiedenen thermischen Bedingungen. Dargestellt ist hier die Oberkante 200 einer Leiterbahn 20 eines Substrats 2. Auf dieser Leiterbahn 20 sind zwei Leistungshalbleiterbauelemente 3 angeordnet und mittels einer Verbindungseinrichtung 5 elektrisch leitend verbunden.

Es kann sich bei diesen Leistungshalbleiterbauelementen 3 beispielhaft um zwei parallel geschaltete Dioden, insbesondere Leistungsdioden, handeln.

Die Verbindungseinrichtung ist hier ausgebildet als ein Folienverbund 5 aus einer elektrisch leitenden und einer elektrisch isolierenden Folie 50, 52. Die elektrisch isolierende Folie 52 ist hierbei in dem dargestellten Bereich nicht strukturiert und damit durchgehend ausgebildet. Die elektrisch leitende Folie 50 ist in sich strukturiert, wobei ein Abschnitt dieser Folie, eine Folienleiterbahn 500, das linke Leistungshalbleiterbauelement 3 an dessen dem Substrat 2 abgewandter Kontaktfläche kontaktiert. Ein weiterer Abschnitt überbrückt den Bereich zwischen dieser Kontaktfläche und der Kontaktfläche 302 des rechten Leistungshalbleiterbauelements 3, während ein dortiger Abschnitt 502 diese Kontaktfläche 302 kontaktiert. Auf diese Weise sind die beiden Leistungshalbleiterbauelementen 3, genauer ihre dem Substrat 2 abgewandten Kontaktflächen 302 mittels einer leitenden Folie, genauer eine Folienleiterbahn 500, elektrisch leitend miteinander verbunden.

Die dem Substrat 2 abgewandte Kontaktfläche 302 des Leistungshalbleiterbauelements 3 ist mit einer weiteren Folienleiterbahn 510 der elektrisch leitenden Folie 50 kontaktiert, wobei die beiden Folienleiterbahnen 500, 510 der elektrisch leitenden Folie 50 selbst nicht unmittelbar elektrisch leitend verbunden sind, vielmehr ist zwischen ihnen ein zweiter breiter Schlitz 8 ausgebildet.

Im Zwischenraum zwischen den Rändern 304 der Leistungshalbleiterbauelementen 3, nach unten begrenzt durch die Leiterbahn 20 und nach oben begrenzt durch die Verbindungseinrichtung 5 ist eine Vergussmasse 4 angeordnet. Diese Vergussmasse 4 dient der elektrischen Isolation zwischen dem Potential der Leiterbahn 20 und dem Potential der Folienleiterbahn 500 der leitenden Folie 50 der Verbindungseinrichtung 5. Eine derartige Isolation ist aufgrund der Potentialdifferenz in der Größenordnung von einem Kilovolt zwingend notwendig.

Figur 1 zeigt die Vergussmasse 4 in einem Grundzustand, beispielhaft bei einer niedrigen Temperatur, wobei die Oberfläche 40 annährend eben erläuft und diese Ebene durch die Oberflächen der Leistungshalbleiterbauelemente 3 definiert ist. Figur 2 zeigt die Vergussmasse 40 bei einer höheren Temperatur der Leistungsbaugruppe 1. Aufgrund des um mindestens eine Größenordnung, häufig sogar zwei Größenordnungen, größeren thermischen Ausdehnungskoeffizienten der Vergussmasse 4 im Vergleich zu den Leistungshalbleiterbauelementen 3 wölbt diese Vergussmasse 4 den Folienverbund der Verbindungseinrichtung 5 auf, da diese die geringste mechanische Stabilität im Vergleich zu den Leistungshalbleiterbauelementen 3 und dem Substrat 2 aufweist.

Eine derartige Auswölbung erzeugt mechanische Belastungen auf den Folienverbund 5 selbst und auch auf die Verbindung der Folienleiterbahnen 500, 510 mit den Kontaktflächen 302 der Leistungshalbleiterbauelemente 3. Typischerweise ist die Verbindung der Kontaktflächen 302 der Leistungshalbleiterbauelemente 3 und der leitenden Folie 50 als stoffschlüssige Verbindung, insbesondere als Drucksinterverbindung, ausgebildet. Häufig ist diese stoffschlüssige Verbindung insbesondere deren Rand 306, also der Übergang zwischen der Kontaktfläche 302 zu der nicht als Kontaktfläche dienenden Oberfläche des Leistungshalbleiterbauelements 3 ein Bereich in dem eine mechanischen Belastung zu Beschädigungen der stoffschlüssigen Verbindung führt. Derartige Beschädigungen können im Dauerbetrieb der Leistungsbaugruppe 1 und den damit üblicherweise verbundenen thermischen Schwankungen bis zum Ausfall der Leistungsbaugruppe führen.

Figur 3 zeigt eine schematische Draufsicht auf eine erfindungsgemäße Leistungsbaugruppe. Dargestellt ist hier die Lage einfacher Schlitze 6, sowie die Ausschnittsvergrößerung von zweien dieser einfachen Schlitze 6. Die einfachen Schlitze 6 sind hier ausgebildet als eine Mehrzahl durchgehender einfacher Schlitze mit gleichem Abstand zueinander. Jeder einfache Schlitz 6 ist weiterhin ausgebildet mit jeweils drei Parallelabschnitten 604, 606, 608, wobei der erste und dritte Parallelabschnitt 604, 608 auf einer gedachten Geraden angeordnet sind, während der zweite Parallelabschnitt 606 zu den anderen Parallelabschnitten parallel beabstandet verläuft. Die jeweiligen Parallelabschnitte 604, 606, 608 sind mittels Übergangsbereichen miteinander verbunden. Ein Abstandspunkt 600 ist auf dem zweiten Parallelabschnitt 606, und dort aufgrund des parallelen Verlaufs zu den anderen Parallelabschnitten 604, 608 auf diesem Parallelabschnitt beliebig, angeordnet.

Der Abstandspunkt 600 weist von der die Eckpunkte 602 verbindenden Geraden, hier einer Geraden die den ersten und dritten Parallelabschnitt 604, 068 einschließt einen Abstand 612 von ca. dem 3-fachen, des Abstandes 610 korrespondierender benachbarter Schlitze auf.

Jeweils zwei benachbarte einfache Schlitze 6 bilden zwischen einander einen Schnittflächenabschnitt 66 aus, der teilweise durch die thermische Ausdehnung der Vergussmasse aus seiner Position verdreht wird.

Figur 3 zeigt weiterhin erste breite Schlitze 7, die von der Kontaktfläche 302 des linken Leistungshalbleiterbauelements 3 ausgehend über den Rand 306 dieser Kontaktfläche 302 hinausragen, allerdings hier nicht über den Rand 304 des Leistungshalbleiterbauelements 3 selbst hinaus gehen. Vielmehr enden diese ersten breiten Schlitze 7 an einer lateralen Position, bevor die einfachen Schlitze 6 beginnen.

Dem zweiten Leistungshalbleiterbauelement 3 sind ebenfalls erste breite Schlitze 7 zugeordnet, die wiederum ausgehend von der Kontaktfläche 302 über den Rand 306 dieser Kontaktfläche hinausragen. Diese ersten breiten Schlitze 7 gehen fluchtend in einfache Schlitze 6 über, wobei hier nicht jedem einfachen Schlitz 6 ein erster breiter Schlitz 7 zugeordnet ist.

Zur Verdeutlichung der jeweiligen Lage relevanter Merkmale sind in den Figuren 1 bis 3 strichpunktierte Linien eingetragen, die folgende Positionen in ihrem lateralen Verlauf von links nach rechts bezeichnen:
- "x1": kennzeichnet den Rand 306 der Kontaktfläche 302 des linken Leistungshalbleiterbauelements 3; an diesen Rand schließt sich die Oberfläche dieses Leistungshalbleiterbauelements 3 an, die nicht der elektrischen Verbindung dient.
- "x2": kennzeichnet ein Ende erste breiter Schlitze 7 im Bereich der nicht zur Kontaktfläche gehörenden Oberfläche des linken Leistungshalbleiterbauelements 3, wobei der das andere Ende dieser breiten Schlitze 6 oberhalb der Kontaktfläche 302 dieses Leistungshalbleiterbauelements 3 liegt.
- "x3": kennzeichnet den Beginn der einfachen Schlitze 6, hier insbesondere den Beginn eines ersten Parallelabschnittes 604, oberhalb der Oberfläche des Leistungshalbleiterbauelements 3, allerdings nicht im Bereich von dessen Kontaktfläche 302.
- "x4": kennzeichnet das Ende des ersten Parallelabschnittes 604 eines einfachen Schlitzes 5 und damit den Beginn des Übergangsbereichs des einfachen Schlitzes 5 der zum zweiten Parallelbereich 606 führt.
- "x5": kennzeichnet den Rand 304 des linken Leistungshalbleiterbauelements 3.
- "x6": kennzeichnet das Ende des Übergangsbereichs des einfachen Schlitzes 6 und den Beginn des zweite Parallelabschnitts 606.
- "x7": kennzeichnet den Rand 304 des rechten Leistungshalbleiterbauelements 3.
- "x8": kennzeichnet den Beginn 306 der Kontaktfläche 302 des rechten Leistungshalbleiterbauelements 3.

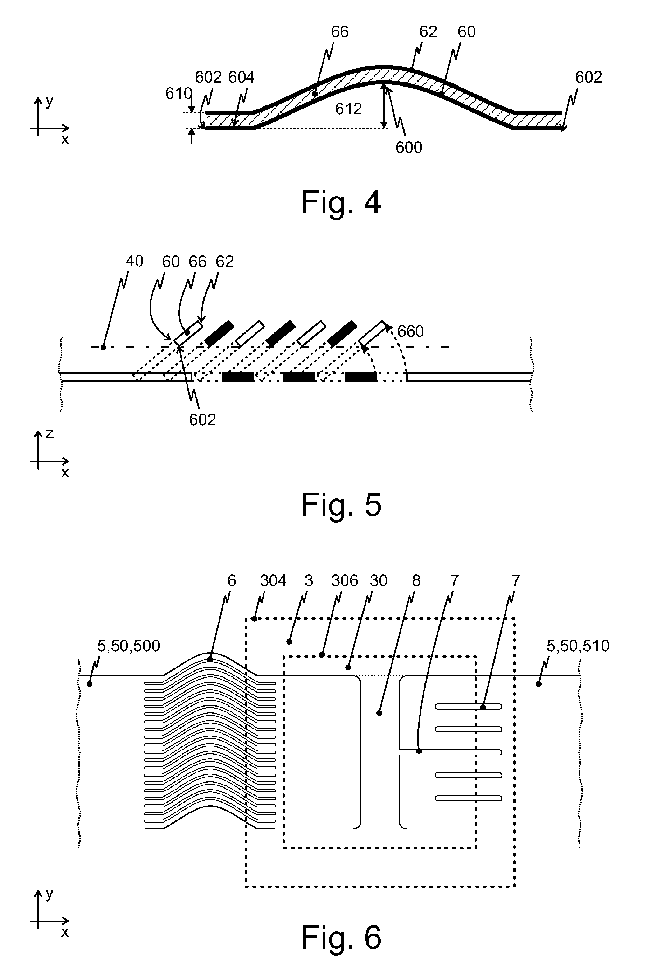

Figur 4 zeigt eine schematische Teilansicht einer erfindungsgemäßen Leistungsbaugruppe in Draufsicht, analog der Ausschnittsvergrößerung bei Figur 3, allerdings in anderer Ausgestaltung der einfachen Schlitze 6. Diese einfachen Schlitze weisen im Mittelabschnitt einen bogenförmigen Verlauf auf, wobei der Abstandpunkt 600 einen Abstand 612 von der die Eckpunkte 602 verbindenden Geraden von ca. dem 2-fachen, des Abstandes 610 korrespondierender benachbarter Schlitze 60, 62 aufweist.

Figur 5 zeigt eine schematische Schnittansicht eines Teilausschnitts einer erfindungsgemäßen Leistungsbaugruppe und hierbei insbesondere die Wirkung einfacher Schlitze 6 bei thermischer Ausdehnung der Vergussmasse. Durch diese Ausdehnung wird nicht, wie in Fig. 2 dargestellt der gesamte Folienverbund in dem Abschnitt oberhalb der Vergussmasse ausgewölbt, sondern die einzelnen Schnittflächenabschnitte 66 werden partiell in ihrem Mittelabschnitt durch eine Drehbewegung aus ihrer Reihenanordnung heraus bewegt.

Durch diese Drehbewegung der Mittelabschnitte der Schnittflächenabschnitte 66 wird die Kraftwirkung der thermischen Ausdehnung der Vergussmasse aufgenommen, die somit Raum zur Ausdehnung hat, ohne dass auf benachbarte Verbindungen der Folienleiterbahnen mit einer Kontaktfläche Kraft ausgeübt wird, die diese Verbindung beschädigen kann.

Dargestellt sind eine Mehrzahl von Schnittflächenabschnitt 66, sowohl in ihrer Grundposition als auch in ihrer um einen Drehwinkel 660 ausgelenkten Position. Die strichpunktiere Linie deutet schematisch die Oberkante 40 der Vergussmasse bei thermischer Ausdehnung an.

Figur 6 zeigt eine weitere schematische Draufsicht auf eine erfindungsgemäße Leistungsbaugruppe. Dargestellt ist ein Leistungshalbleiterbauelement 3 mit einer Kontaktfläche 302. Dieser Kontaktfläche 302 ist mittels einer elektrisch leitende Folie 50 als Teil einer Verbindungseinrichtung 5 verbunden, wobei diese elektrisch leitenden Folie 50 hier zweite Folienleiterbahnen 500, 510 gleichen Potentials, aber ohne unmittelbare Verbindung aufweist. Die elektrisch leitende Folie 50 weist somit einen zweiten breiten Schlitz 8 auf. Die leitende Verbindung der beiden Folienleiterbahnen 500, 510 wird mittels der Kontaktfläche 302 des Leistungshalbleiterbauelements 3 mittelbar hergestellt. Ein derartiger zweiter breiter Schlitz 8 dient somit auch der Verringerung thermisch induzierter Kräfte auf die Verbindung des Folienverbunds 5 mit der Kontaktfläche 302 des Leistungshalbleiterbauelements 3.

Weiterhin weist die rechte Folienleiterbahn 510 der elektrisch leitenden Folie 50 erste breite Schlitze 7 auf, von denen einer in den zweiten breiten Schlitz 8 übergeht. Hierbei weisen die beiden Schlitze einen rechten Winkel zueinander auf. Zudem ist der Übergangspunkt vom ersten breiten Schlitz mittig in dem zweiten breiten Schlitz angeordnet.

Ebenfalls dargestellt sind einfache Schlitze 6 in der linken Folienleiterbahn 500 die grundsätzlich denjenigen gemäß Figur 4 entsprechen.

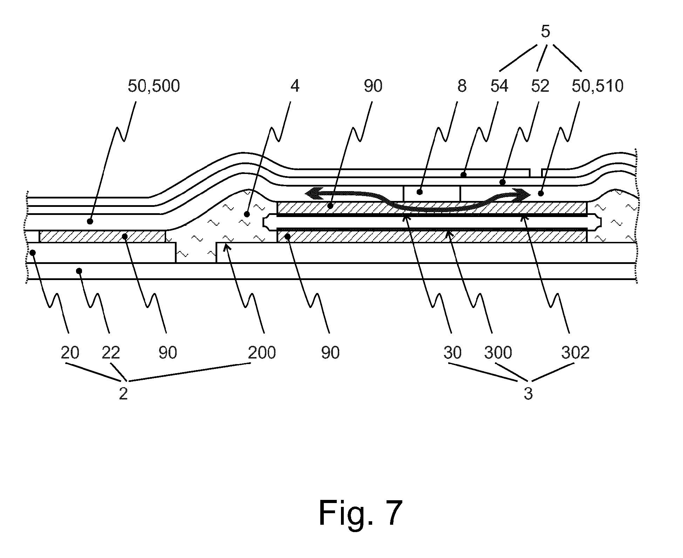

Figur 7 zeigt eine erfindungsgemäße Leistungsbaugruppe in schematisierter Teilansicht. Dargestellt ist hierbei ein Substrat 2, mit einem elektrisch isolierenden Grundkörper 22 beispielhaft in Form einer Keramikplatte, und mit Leiterbahnen 20 unterschiedlichen Potentials, beispielhaft ausgebildet als Kupferflächen auf dem Grundkörper 22.

Auf einer Leiterbahn 20 ist ein Leistungshalbleiterbauelement 3 angeordnet, indem dessen dem Substrat 2 zugewandte Kontaktfläche 300 mittels einer stoffschlüssigen Verbindung 90, hier eine Sinter- oder Lotverbindung, elektrischen leitend mit der Leiterbahn 20 verbunden ist. Die dem Substrat 2 abgewandte Kontaktfläche 302 des Leistungshalbleiterbauelements 3 ist, ebenfalls mittels einer stoffschlüssigen Verbindung 90, mit einer leitenden Folie 50 einer Verbindungseinrichtung 5 verbunden. Hierbei weist die leitende Folie 50 einen zweiten breiten Schlitz 8 auf. Die Kontaktfläche 302 in Kombination mit dem Lot oder der Sinterschicht 90 bilden hierbei die mittelbare elektrische Verbindung, angedeutet durch den Doppelpfeil, mit der Folienleiterbahnen 500, 510 der elektrisch leitenden Folie 50 aus. Der zweite breite Schlitz 8 ist hier als Schlitz einer Folienlage ausgebildet.

Die Folienleiterbahn 500 der elektrisch leitenden Folie 50, die an der Kontaktfläche 302 des Leistungshalbleiterbauelements 3 mit diesem verbunden ist überdeckt eine Vergussmasse 4 und ist in ihrem weiteren Verlauf, wiederum mittels einer stoffschlüssigen Verbindung 90, mit einer weiteren Leiterbahn 20 verbunden.

Die Verbindungseinrichtung 5 weist neben der beschriebenen leitenden Folie 50 noch eine isolierende Folie 52 sowie eine weitere leitende Folie 54 auf, die hier eine zur ersten leitenden Folie, unterschiedliche Dicke aufweist.

Es versteht sich, dass diese Darstellungen jeweils nur erläuternden Charakter haben. Die Anordnung verschiedener Ausprägungen von Schlitzen, die Ausgestaltung als durchgehender Schlitz oder Schlitz einer Folienlage, wie auch deren ggf. sinnvolle oder notwenige Verbindungen an definierten Übergangspunkten hängt von der Anwendung und von der konkreten Ausgestaltung der Leistungsbaugruppe ab.

## Patentansprüche

1. Leistungsbaugruppe (1) mit einem Leiterbahnen (20) aufweisendem Substrat (2) hierauf angeordneten Leistungshalbleiterbauelementen (3) und mit einer Verbindungeinrichtung (5), ausgebildet als Folienverbund mit einer isolierenden Folie (52) und einer elektrisch leitenden Folie (50), die in Abschnitten jeweils mit einer Kontaktfläche (302) eines Leistungshalbleiterbauelements (3) oder mit einer Kontaktfläche einer Leiterbahn (20) des Substrats (2) stoffschlüssig verbunden ist, wobei der Folienverbund aufweist:
• eine Mehrzahl in gleichem Abstand zueinander verlaufender einfacher Schlitze (6), wobei zwei benachbarte einfache Schlitze (60, 62) keinen durchgängig geraden Verlauf aufweisen, sondern jeder einfache Schlitz (60) mindestens einen Abstandspunkt (600) in seinem Verlauf aufweist, der von der die Eckpunkte (602) dieses einfachen Schlitzes verbindenden Geraden einen minimalen Abstand (612) aufweist, der größer ist als der maximale Abstand (610) zum in diese Richtung benachbarten einfachen Schlitz (62), und / oder
• einen ersten breiten Schlitz (7), der von einer Kontaktfläche (302) ausgehend über den Rand (306) dieser Kontaktfläche (302) hinausragt, und / oder
• einen zweiten breiten Schlitz (8), der den mit einer Kontaktfläche (302) in Kontakt stehenden Abschnitt (502) der elektrisch leitenden Folie (50) in zwei nicht direkt miteinander elektrisch leitend verbundene Teilabschnitte, die somit Folienleiterbahnen (500, 510) ausbilden, unterbricht.

2. Leistungsbaugruppe nach Anspruch 1, wobei
der Abstand des Abstandspunktes (600) von der die Eckpunkte (602) verbindenden Geraden mindestens dem 1,5-fachen, insbesondere mindestens dem 2-fachen, des Abstandes (610) korrespondierender benachbarter Schlitze (60, 62) entspricht.

3. Leistungsbaugruppe nach Anspruch 1, wobei
ein einfacher (6), ein erster breiter (7) oder ein zweiter breiter Schlitz (8) in einen Schlitz einer anderen Ausprägung übergeht.

4. Leistungsbaugruppe nach Anspruch 3, wobei
bei einem Übergang von einem Schlitz in einen Schlitz anderer Ausprägung, die beiden Schlitze am Übergangspunkt einen Winkel zueinander einschließen.

5. Leistungsbaugruppe nach Anspruch 4, wobei
der Übergangspunkt am Ende eines Schlitzes und im Verlauf, also nicht an einem Ende, des Schlitzes anderer Ausprägung liegt.

6. Leistungsbaugruppe nach Anspruch 3, wobei
bei einem Übergang von einem Schlitz in einen Schlitz anderer Ausprägung, die beiden Schlitze am Übergangspunkt zueinander fluchten.

7. Leistungsbaugruppe nach Anspruch 1, wobei
eine Mehrzahl einfacher Schlitze (6) mit gleichem Abstand (610) zueinander ausgebildet sind mit jeweils drei Parallelabschnitten (604, 606, 608), wobei der erste und dritte Parallelabschnitt (604, 608) auf einer gedachten Geraden angeordnet sind während der zweite Parallelabschnitt (606), auf dem der Abstandspunkt (600) angeordnet ist, zu den anderen Parallelabschnitten parallel verläuft.

8. Leistungsbaugruppe nach einem der vorhergehenden Ansprüche, wobei mindestens ein einfacher Schlitz (6) als durchgehender Schlitz ausgebildet ist.

9. Leistungsbaugruppe nach einem der vorhergehenden Ansprüche, wobei mindestens ein erster und / oder ein zweiter breiter Schlitz (7, 8) als Schlitz einer Folienlage einer leitenden Folie (50) ausgebildet ist.
